Europäisches Patentamt

European Patent Office

Office européen des brevets

(11) Veröffentlichungsnummer: **0 482 380 A2**

# EUROPÄISCHE PATENTANMELDUNG

(21) Anmeldenummer: **91116578.5**

(22) Anmeldetag: **27.09.91**

(51) Int. Cl.5: **H03M 1/24**, G01F 23/46

(30) Priorität: **26.10.90 DE 4034173**

(43) Veröffentlichungstag der Anmeldung:
**29.04.92 Patentblatt 92/18**

(84) Benannte Vertragsstaaten:
**DE FR GB IT**

(71) Anmelder: **HEEL GMBH & CO. MESSTECHNIK KG**
**Jägerstrasse 4-12**
**W-8960 Kempten(DE)**

(72) Erfinder: **Heel, Helmut**
**Andreas-Mayer-Strasse 82 1/8**
**W-8951 Lengenwang(DE)**
Erfinder: **Baur, Heinrich**
**Stadel 16**
**W-8901 Dinkelscherben(DE)**
Erfinder: **Fend, Peter, Dipl.-Ing. (FH)**
**Elsterweg 3**
**W-8960 Kempten(DE)**
Erfinder: **Iven, Albert, Ing. grad.**
**Seibthübelweg 6**
**W-8950 Kaufbeuren 2(DE)**

(74) Vertreter: **Liska, Horst, Dr.-Ing. et al**
**Patentanwälte H. Weickmann, Dr. K. Fincke,**
**F.A. Weickmann, B. Huber, Dr. H. Liska, Dr. J.**
**Prechtel Kopernikusstrasse 9 Postfach 86 08**
**20**
**W-8000 München 86(DE)**

(54) **Winkelkodierer, insbesondere für ein Hydrometrie-Messgerät.**

(57) Für ein Hydrometrie-Meßgerät wird ein Winkelkodierer vorgeschlagen, welcher im Abstand von der Drehachse eines Rotors (17) mehrere Paare in Umfangsrichtung des Rotors (17) um gleiche Winkelabstände gegeneinander versetzte, abwechselnd gegensinnig gepolte Permanentmagnete (19) trägt. Der Rotor ist außerhalb eines Gehäuses (13) angeordnet, welches in seinem Inneren die Magnetdrahtsensoren (25) und eine deren Impulse zählende Zählschaltung abgedichtet umschließt. Die Magnetdrahtsensoren (25) sprechen durch die Gehäusewand hindurch auf die Permanentmagnete (19) an. Ein Winkelkodierer dieser Art hat eine sehr geringe Stromaufnahme und schützt seine elektronischen Komponenten dauerhaft gegen Korrosion.

Fig.1

Die Erfindung betrifft einen Winkelkodierer, insbesondere für ein batterie- oder akkumulatorbetriebenes Hydrometrie-Meßgerät, mit einem Gehäuse, wenigstens einem um eine Drehachse drehbar an dem Gehäuse gelagerten Rotor, welcher im Abstand von der Drehachse mehrere Paare in Umfangsrichtung des Rotors um gleiche Winkelabstände gegeneinander versetzter, abwechselnd gegensinnig gepolter Permanentmagnete trägt, und wenigstens einem an dem Gehäuse gehaltenen Magnetdrahtsensor, der auf die Ummagnetisierung seines ferromagnetischen Drahts mittels der Permanentmagnete durch Abgabe eines Spannungsimpulses reagiert.

Für die laufende Registrierung des Wasserstands von fließenden und stehenden Gewässern oder für die Grundwasser-Pegelmessung werden netzunabhängige Pegelmeßgeräte eingesetzt, die mittels eines an einem Seil hängenden Schwimmers den Pegelstand verfolgen. Das Schwimmerseil ist über eine Seilrolle geführt, die auf der Achse eines mehrgängigen Potentiometers oder eines über ein Getriebe angetriebenen Winkelkodierers sitzt. Die Meßgenauigkeit von Wegmeßgebern der vorstehenden Art ist begrenzt, da mit wachsender Gängezahl des Potentiometers bzw. mit wachsender Untersetzung des den Winkelkodierer treibenden Getriebes das Antriebsmoment unerwünscht hohe Werte annimmt. Darüber hinaus haben Wegmeßgeber der vorstehenden Art einen vergleichsweise hohen Stromverbrauch, was einen vergleichsweise häufigen Batteriewechsel des ansonsten wartungsfrei betreibbaren Pegelmeßgeräts erforderlich macht. Da Pegelmeßgeräte vielfach frei der Witterung ausgesetzt sind, werden an die Abdichtung der Wegmeßgeber sehr hohe Anforderungen gestellt, wenn ein betriebssicherer Dauerbetrieb erreicht werden soll.

Es ist bekannt, Drehwinkelkodierer mit Hilfe von Magnetdrahtsensoren aufzubauen. Kodierer dieser Art haben einen Rotor, auf welchem eine Vielzahl in Umfangsrichtung verteilter, um gleiche Winkelabstände gegeneinander versetzter und abwechselnd gegensinnig gepolter Permanentmagnete angeordnet sind. Der Magnetdrahtsensor, vielfach auch Impulsdrahtsensor oder Wiegand-Drahtsensor genannt, umfaßt einen üblicherweise unter Zugspannung stehenden Draht aus ferromagnetischem Material, der durch das Magnetfeld der Permanentmagnete sprunghaft ummagnetisiert wird, sobald bei Annäherung des Permanentmagnets an den Magnetdraht das äußere Magnetfeld einen ausreichend hohen Wert erreicht. In einer dem Magnetdraht benachbarten, ihn vorzugsweise umschließenden Induktionsspule wird beim Umschalten ein Spannungsimpuls induziert, der als Maß für eine vorgegebene Winkelposition des Permanentmagnets und damit des Rotors relativ zum Magnetdrahtsensor ausgewertet werden kann. Die Permanentmagnete folgen mit abwechselnder Polarität aufeinander, wobei der Magnetdrahtsensor jeweils von Permanentmagneten der einen Polarität gesetzt und von Permanentmagneten der anderen Polarität rückgesetzt wird.

Es ist Aufgabe der Erfindung, einen Winkelkodierer anzugeben, der die an eine Verwendung in einem Hydrometrie-Meßgerät gestellten Forderungen erfüllt, insbesondere keinen oder sehr geringen Stromverbrauch hat und auch bei sehr langer Betriebsdauer unter ungünstigen Bedingungen korrosionsgeschützt ist.

Ausgehend von dem eingangs erläuterten Winkelkodierer wird diese Aufgabe erfindungsgemäß dadurch gelöst, daß eine die Impulse zählende Zählschaltung vorgesehen ist und das Gehäuse die Magnetdrahtsensoren und die Zählschaltung abgedichtet umschließt, daß der Rotor einschließlich der Permanentmagnete außerhalb des Gehäuses angeordnet ist und daß jeder Magnetdrahtsensor durch die Gehäusewand hindurch auf die Permanentmagnete anspricht.

Bei einem solchen Winkelkodierer sind die korrosionsanfälligen elektronischen Komponenten abgedichtet innerhalb des vorzugsweise mit Gießharz ausgefüllten Gehäuses untergebracht, während die mechanisch bewegten Komponenten sämtlich außerhalb des Gehäuses vorgesehen sind. Verschleißanfällige Dichtungen zwischen bewegten Komponenten und dem Gehäuseinneren entfallen damit vollständig. Der Winkelkodierer hat ein außerordentlich geringes Antriebsmoment, da nur der Rotor bewegt werden muß und dieser berührungsfrei von den Magnetdrahtsensoren abgetastet wird. Die Magnetdrahtsensoren haben ihrerseits keinen Stromverbrauch.

In einer insbesondere für die Verwendung bei einem Hydrometrie-Meßgerät geeigneten Ausgestaltung der Erfindung ist der Rotor an einem feststehenden, am Gehäuse gehaltenen Achszapfen drehbar gelagert und weist ein an dem Achszapfen drehbar gelagertes Nabenteil auf, welches zwei relativ zueinander drehbare Rotorräder axial nebeneinander trägt. Wenigstens eines der Rotorräder ist relativ zum Nabenteil axial beweglich auf diesem geführt und wird von einer am Nabenteil abgestützten Feder im Reibschluß mit dem anderen Rotorrad gehalten. Das dem Gehäuse benachbarte Rotorrad trägt die Permanentmagnete, und das andere Rotorrad ist mit einem Antriebsorgan, insbesondere einer Seilrolle oder dergleichen, versehen. Die Rotorräder können auf diese Weise gegen den Reibschluß relativ zueinander justiert werden, um die Winkelposition der Permanentmagnete relativ zur Winkelposition der Antriebsverbindung justieren zu können. Um die Justierung zu erleichtern, sind die Rotorräder zweckmäßigerweise an ihrem Umfang mit einer Rändelung versehen.

In einer bevorzugten Ausgestaltung sind die Permanentmagnete als Stabmagnete ausgebildet, so daß sich gegebenenfalls zusätzliche Joche oder dergleichen erübrigen. Die Stabmagnete und auch die Magnetdrahtsensoren können mit ihrer Stab- bzw. Drahtachse radial angeordnet sein, wodurch sich in axialer Richtung besonders flache Winkelkodierer erzielen lassen. Alternativ können die Permanentmagnete und die Magnetdrahtsensoren mit ihren Achsen auch parallel zur Drehachse ausgerichtet sein. Dies hat den Vorteil, daß sich eine besonders hohe Auflösung des Winkelkodierers erreichen läßt.

In einer zweckmäßigen Ausgestaltung sind mehrere Magnetdrahtsensoren um die Drehachse herum um gleiche Winkelabstände gegeneinander versetzt angeordnet. Ein Winkelkodierer dieser Art hat selbst bei verhältnismäßig geringer Anzahl an Permanentmagneten eine hohe Winkelauflösung. Wenn der Winkelabstand benachbarter Magnetdrahtsensoren ein ungeradzahliges Vielfaches des halben Winkelabstandes der Permanentmagnete beträgt, läßt sich eine hohe Auflösung mit sicherer Erfassung der Schaltpositionen vereinigen. Eine speziell für radiale Anordnung und damit axial flache Winkelkodierer geeignete Ausführungsform umfaßt vier Magnetdrahtsensoren und wenigstens fünf Paare von Permanentmagneten.

In Ausführungsformen in welchen eine gerade Anzahl um gleiche Winkelabstände gegeneinander versetzte Magnetdrahtsensoren vorgesehen ist, läßt sich eine Drehrichtungserkennung realisieren. In einer Ausgestaltung, die zugleich den Vorteil hoher Winkelauflösung hat, ist vorgesehen, daß die gerade Anzahl um gleiche Winkelabstände gegeneinander versetzten Magnetdrahtsensoren in zwei Gruppen angeordnet sind, derart daß die Magnetdrahtsensoren der einen Gruppe jeweils zwischen Magnetdrahtsensoren der anderen Gruppe gelegen sind. Die Zählrichtung der Zählerschaltung ist hierbei mittels einer Drehrichtungserkennungsschaltung umschaltbar, welche die Zählrichtung umkehrt, wenn zwei Impulse von Magnetdrahtsensoren derselben Gruppe aufeinanderfolgen.

Werden sämtliche von den Magnetdrahtsensoren erzeugten Impulse gezählt, läßt sich eine hohe Auflösung erreichen. In einer bevorzugten Ausgestaltung ist jedoch vorgesehen, daß zwar die Drehrichtungserkennnungsschaltung auf die Impulse von Magnetdrahtsensoren beider Gruppen anspricht, die Zählerschaltung jedoch ausschließlich Impulse von Magnetdrahtsensoren einer einzigen der beiden Gruppen zählt, so daß Hysteresefehler beim Umschalten der Zählrichtung innerhalb der Schrittgenauigkeit vermieden werden.

Im folgenden wird ein Ausführungsbeispiel der Erfindung anhand einer Zeichnung näher erläutert. Hierbei zeigt:

Fig. 1     eine Schnittansicht eines erfindungsgemäßen Winkelkodierers, eingebaut in einen Pegelmesser;

Fig. 2     eine schematische Draufsicht auf einen Rotor des Winkelkodierers;

Fig. 3     ein Blockschaltbild einer Auswerteschaltung des Winkelkodierers und

Fig. 4     eine schematische Darstellung einer Variante eines Rotors für einen Winkelkodierer.

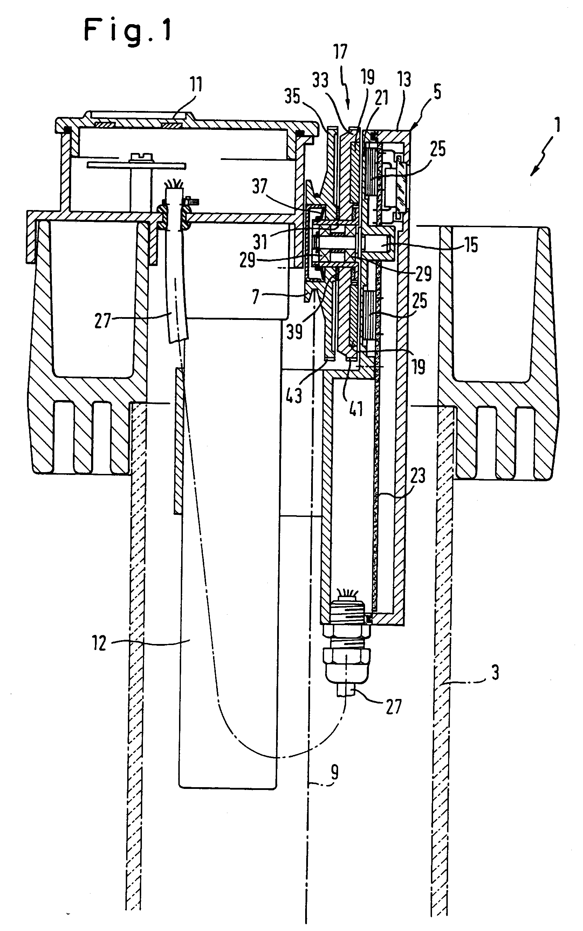

Fig. 1 zeigt einen Pegelmeßkopf 1 eines Grundwasser-Pegelmessers, aufgesetzt auf ein Brunnenrohr 3. Der Pegelmesser 1 umfaßt einen Winkelkodierer 5 mit einer Seilrolle 7, über die ein beiderseits in das Brunnenrohr 3 hängendes Seil 9 läuft. Das Seil 9 trägt an seinem einen Ende einen nicht näher dargestellten Schwimmer und ist an seinem anderen Ende durch ein ebenfalls nicht dargestelltes Gegengewicht belastet. Der Winkelkodierer 5 liefert dem absoluten Pegelstand entsprechende digitale Signale, die in einem Datensammelspeicher gesammelt und über eine Schnittstelle 11 bei Bedarf abgerufen werden können. Der Pegelmesser wird netzunabhängig über Batterien oder Akkumulatoren betrieben, die in einem Batteriekasten 12 untergebracht sind.

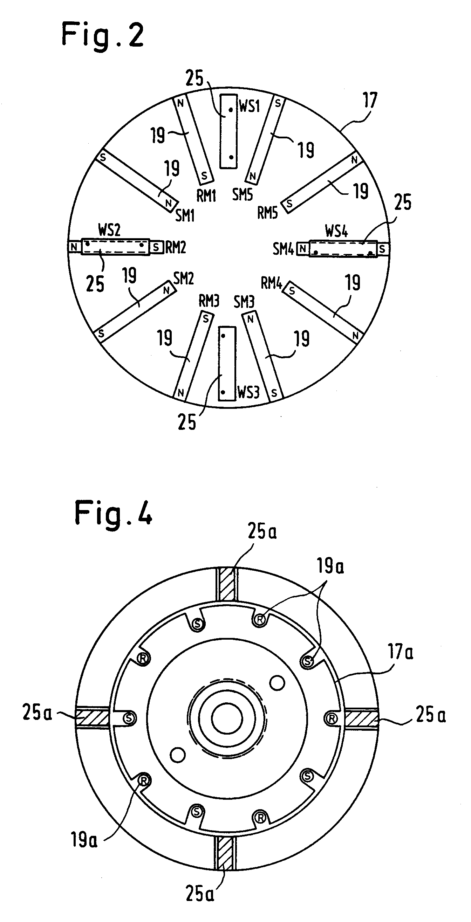

Der Winkelkodierer 5 hat ein vollständig geschlossenes, nach außen abgedichtetes Gehäuse 13, das an einem gehäusefesten Achszapfen 15 einen mit der Seilrolle 7 versehenen Rotor 17 frei drehbar trägt. Der Rotor 17 ist auf der zum Gehäuse 5 zugewandten Seite mit einer ungeraden Anzahl von Paaren von Permanentmagneten 19, hier 5 Paare, versehen. Die Permanentmagnete 19 sind, wie am besten Fig. 2 zeigt, als Stabmagnete ausgebildet und mit ihrer Stabachse radial zur Drehachse des Achszapfens 15 in gleichen Winkelabständen voneinander und mit abwechselnder Polarität angeordnet.

Innerhalb des Gehäuses 13, d.h. durch Wände 21 abgedeckt, sind auf einer Schaltungsplatte 23 vier um 90° gegeneinander winkelversetzte Magnetdrahtsensoren 25 den Permanentmagneten 19 axial benachbart angeordnet. Die Magnetdrahtsensoren sind mit der Achse ihres ferromagnetischen Drahts ebenfalls radial zur Drehachse des Rotors 17 angeordnet und haben Induktionsspulen, die bei einer Ummagnetisierung durch das Feld der Permanentmagnete 19 einen Spannungsimpuls erzeugen. Da in Umfangsrichtung aufeinanderfolgende Permanentmagnete 19 des Rotors 17 abwechselnde Polarität haben, werden die Magnetdrahtsensoren von aufeinanderfolgenden Permanentmagneten 19 abwechselnd gesetzt bzw. rückgesetzt.

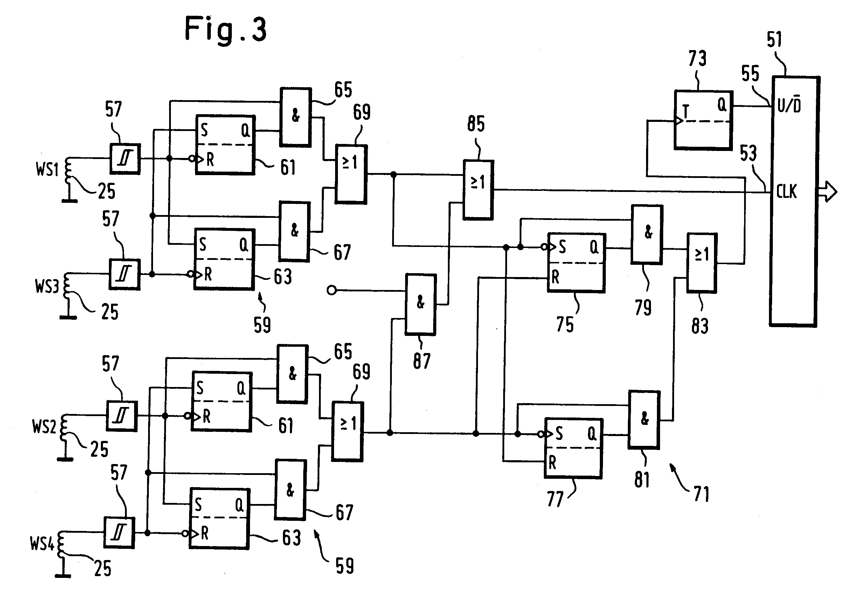

Eine nachfolgend anhand von Fig. 3 näher erläuterte Auswerteschaltung zählt die Impulse der Magnetdrahtsensoren 25 und liefert ein der absoluten Position des Schwimmers proportionales digitales Signal. Die Auswerteschaltung ist in dem Gehäuse 13 auf der Schaltungsplatte 23 korrosionsgeschützt untergebracht, wobei das Gehäuse insbesondere auch mit Gießharz ausgegossen sein kann. Die Schaltungsplatte 23 kann darüber hinaus auch den vorstehend erwähnten Datensammelspeicher enthalten. Ein Verbindungskabel 27 verbindet die elektronische Schaltung mit der von außen zugänglichen Schnittstelle 11, bei der es sich um eine Infrarot-Schnittstelle oder dergleichen handeln kann.

Der Rotor 17 ist außerhalb des Gehäuses 13 in Kugellagern 29 leicht gängig drehbar gelagert und umfaßt eine hülsenförmige Nabe 31, auf der zwei Rotorräder 33, 35 axial nebeneinander und relativ zueinander drehbar sitzen. Das dem Gehäuse 13 axial benachbarte Rotorrad 33 trägt die Permanentmagnete 19, während das andere Rotorrad 35 mit der Seilrolle 7 versehen ist. Das geringfügig axial bewegliche auf der Nabe 31 geführte Rotorrad 35 wird von einer an der Nabe 31 abgestützten Tellerfeder 37 im Reibschluß gegen das Rotorrad 33 gedrückt. Zwischen den Rotorrädern 33, 35 ist zur Erhöhung des Reibmoments ein Reibring 39 angeordnet. Die auf ihrem Außenumfang mit Griffrändelungen 41, 43 versehenen Rotorräder 33, 35 lassen sich damit gegeneinander verdrehen, um eine Anfangsposition des Winkelkodierers relativ zu einer Nullposition des Pegels justieren zu können.

Fig. 3 zeigt Einzelheiten der Auswerteschaltung für einen Winkelkodierer mit vier Magnetdrahtsensoren WS1, WS2, WS3 und WS4 bei einer ungeraden Anzahl von Permanentmagnetpaaren aus jeweils einem Setzmagnet SM und einem benachbarten Rücksetzmagnet RM, wie dies in Fig. 2 für fünf Magnetpaare dargestellt ist. Die Auswerteschaltung umfaßt einen Vorwärts-Rückwärts-Zähler 51, der an seinem Takteingang 53 zugeführte Impulse in einer durch den Pegel an seinem Zählrichtungsumschalteingang 55 bestimmten Zählrichtung zählt. Die von den Magnetdrahtsensoren WS1 bis WS4 erzeugten Impulse werden in Impulsformungsstufen 57 geformt. Beim Einsatz von Magnetdrahtsensoren, welche beim Rücksetzen Impulse entgegengesetzter Polarität abgeben, werden diese Impulse von den Impulsformungsstufen 57 gleichzeitig unterdrückt. Die Impulsselektionsstufen 59, welche jeweils an die Impulsformungsstufen 57 der beiden Sensorpaare WS1, WS3 und WS2, WS4 angeschlossen sind, lassen nur abwechselnd Impulse eines Sensorpaares zum Zähler 51 durch, womit das Fehlen eines Impulses bei einer Drehrichtungsumkehr zusätzlich zur physikalischen Wirkungsweise provoziert wird. Jede der beiden Impulsselektionsstufen 59 umfaßt zwei Flipflops 61, 63, von denen jedes mit einem invertierenden, dynamischen Rücksetzeingang R an die Impulsformungsstufe 57 eines der Magnetdrahtsensoren und mit einem Setzeingang S an die Impulsformungsstufe 57 des anderen Magnetdrahtsensors 19 angeschlossen sind. An die Ausgänge Q der Flipflops 61, 63 sind mit je einem Eingang UND-Gatter 65 bzw. 67 angeschlossen, die mit ihren anderen Eingängen jeweils mit den Rücksetzeingängen R der Flipflops 61, 63 verbunden sind. ODER-Gatter 69 leiten über die UND-Gatter 65, 67 tretende Impulse weiter. Der von der Impulsformungsstufe 57 beispielsweise des Magnetdrahtsensors WS1 erzeugte Impuls setzt das Flipflop 63 bzw. setzt das Flipflop 61 zurück. Das Flipflop 61 führt an seinem Ausgang Q nur dann einen "1"-Pegel, wenn zuvor ein Impuls des Magnetdrahtsensors WS3 aufgetreten war. Am Ausgang des UND-Gatters 65 tritt damit der Impuls des Magnetdrahtsensors WS1 nur dann auf, wenn zuvor ein Impuls des Magnetdrahtsensors WS3 aufgetreten war.

An die ODER-Gatter 69 ist eine Drehrichtungserkennungsschaltung 71 angeschlossen, die jeweils dann einen Ausgangsimpuls zur Umschaltung eines mit dem Zählrichtungseingang 55 verbundenen Toggle-Flipflops 73 abgibt, wenn entweder die Magnetdrahtsensoren des Paars WS1, WS3 oder des Paars WS2, WS4 aufeinanderfolgend zwei Impulse liefern. Bei unveränderter Drehrichtung wechseln sich die Paare WS1, WS3 einerseits und WS2, WS4 andererseits mit der Erzeugung von Impulsen ab. Die Drehrichtungserkennungsschaltung 71 umfaßt zwei Flipflops 75, 77, die mit ihren invertierenden dynamischen Setzeingängen S jeweils an eines der ODER-Gatter 69 und mit ihren Rücksetzeingängen R an das jeweils andere ODER-Gatter 69 angeschlossen sind. Die Ausgänge Q der Flipflops 75, 77 sind mit einem Eingang je eines UND-Gatters 79, 81 verbunden, das mit seinem anderen Eingang an den Setzeingang des jeweiligen Flipflops 75, 77 angeschlossen ist. Die UND-Gatter 79, 81 sind über ein ODER-Gatter 83 mit dem dynamischen Takteingang T des Flipflops 73 verbunden. Jedes der UND-Gatter 79, 81 bleibt für Impulse des zugeordneten ODER-Gatters 69 gesperrt, wenn zuvor ein Impuls des jeweils anderen ODER-Gatters 69 aufgetreten war. Der dem Setzeingang S des Flipflops 75 bzw. 77 zugeführte Impuls kann jedoch durch das UND-Gatter 79 bzw. 81 durchtreten, wenn das Flipflop 75 bzw. 77 zuvor durch einen vorangegangenen Impuls desselben Magnetdrahtsensorpaars WS1, WS3 bzw. WS2, WS4 gesetzt worden ist. Nachfolgende Impulse werden damit drehrichtungskorrekt von dem Zähler 51 aufwärts bzw. abwärts gezählt, ohne daß sich Schrittfehler zur tatsächlichen Position des Rotors17 aufsummieren.

Die Impulse der beiden ODER-Gatter 69 werden über ein ODER-Gatter 85 gemeinsamen dem Takteingang 53 des Zählers 51 zugeführt. In den Impulsweg zwischen dem ODER-Gatter 69 eines der beiden Magnetdrahtsensorpaare, hier des Paars WS2, WS4 und das ODER-Gatter 85 ist zur Steuerung der Auflösung des Winkelkodierers ein Tor in Form eines UND-Gatters 87 geschaltet, welches die Impulse dieses Magnetdrahtsensorpaars für die Verringerung der Auflösung wahlweise sperrt. Da sich die Verringerung der Auflösung nur auf den Zähler 51 auswirkt, nicht jedoch auf die Drehrichtungserkennung, kann die Hysterese beim Umschalten der Zählrichtung innerhalb der Schrittgenauigkeit vermieden werden.

Fig. 4 zeigt eine Variante eines Winkelkodierers, bei dem die als Stabmagnete ausgebildeten Permanentmagnete 19a am Umfang eines beispielsweise topfförmigen Rotors 17a mit zur Drehachse des Rotors 17a paralleler Stabachse angeordnet sind. Die Magnetdrahtsensoren 25a sind mit zur Drehachse paralleler Drahtachse ihrer Magnetdrähte in dem Gehäuse angeordnet. Die Permanentmagnete 19a können, wie in Fig. 4 dargestellt, am Außenumfang des Rotors angeordnet sein, wobei die Magnetdrahtsensoren 25a dementsprechend entlang des Umfangs einer den Rotor 17a aufnehmenden, zylindrischen Aufnahmeöffnung des Gehäuses angeordnet sind. Alternativ können die Permanentmagnete 19a jedoch auch am Innenumfang eines Hohlzylinders vorgesehen sein, in dem ein die Magnetdrahtsensoren 25a tragender zylindrischer Vorsprung eingreift. Die Anordnungsweise und Polarisierung der Magnetdrahtsensoren bzw. Permanentmagnete entspricht dem Ausführungsbeispiel der Fig. 1 und 2. Die Auswerteschaltung kann der Schaltung nach Fig. 3 entsprechen.

**Patentansprüche**

1. Winkelkodierer, insbesondere für ein batterie- oder akkumulatorbetriebenes Hydrometrie-Meßgerät, mit einem Gehäuse (13), wenigstens einem um eine Drehachse drehbar an dem Gehäuse (13) gelagerten Rotor (17), welcher im Abstand von der Drehachse mehrere Paare in Umfangsrichtung des Rotors (17) um gleiche Winkelabstände gegeneinander versetzter, abwechselnd gegensinnig gepolter Permanentmagnete (19) trägt und wenigstens einem an dem Gehäuse (13) gehaltenen Magnetdrahtsensor (25) der auf die Ummagnetisierung seines ferromagnetischen Drahts mittels der Permanentmagnete (19) durch Abgabe eines Spannungsimpulses reagiert, **dadurch gekennzeichnet, daß** eine die Impulse zählende Zählschaltung vorgesehen ist und das Gehäuse (13) die Magnetdrahtsensoren (19) und die Zählschaltung (51) abgedichtet umschließt, daß der Rotor (17) einschließlich der Permanentmagnete (19) außerhalb des Gehäuses (13) angeordnet ist und daß jeder Magnetdrahtsensor (25) durch die Gehäusewand hindurch auf die Permanentmagnete (19) anspricht.

2. Winkelkodierer nach Anspruch 1, dadurch gekennzeichnet, daß der Rotor (17) an einem feststehenden, am Gehäuse (13) gehaltenen Achszapfen (15) drehbar gelagert ist und ein an dem Achszapfen (15) drehbar gelagertes Nabenteil (31) aufweist, welches zwei relativ zueinander drehbare Rotorräder (33, 35) axial nebeneinander trägt, von welchen wenigstens eines (35) relativ zum Nabenteil (31) axial beweglich auf diesem geführt und von einer am Nabenteil (31) abgestützten Feder (37) in Reibschluß mit dem anderen Rotorrad (33) gehalten ist und daß das dem Gehäuse (13) benachbarte Rotorrad (33) die Permanentmagnete (19) trägt und das andere Rotorrad (35) mit einem Antriebsorgan (7), insbesondere einer Seilrolle, versehen ist.

3. Winkelkodierer nach Anspruch 1 oder 2, dadurch gekennzeichnet, daß die Magnetdrahtsensoren (25) und die Zählschaltung (51) in dem Gehäuse (13) eingegossen sind.

4. Winkelkodierer nach einem der Ansprüche 1 bis 3, dadurch gekennzeichnet, daß die Permanentmagnete (19) als Stabmagnete ausgebildet sind und daß die Stabmagnete mit ihrer Stabachse wie auch die Magnetdrahtsensoren (25) mit ihrer Drahtachse radial zur Drehachse ausgerichtet sind.

5. Winkelkodierer nach einem der Ansprüche 1 bis 3, dadurch gekennzeichnet, daß die Permanentmagnete (19a) als Stabmagnete ausgebildet sind und daß die Stabmagnete mit ihrer Stabachse wie auch die Magnetdrahtsensoren (25a) mit ihrer Drahtachse parallel zur Drehachse ausgerichtet sind.

6. Winkelkodierer nach einem der Ansprüche 1 bis 5, dadurch gekennzeichnet, daß mehrere Magnetdrahtsensoren (25) um die Drehachse herum um gleiche Winkelabstände gegeneinander versetzt angeordnet sind.

7. Winkelkodierer nach Anspruch 6, dadurch gekennzeichnet, daß der Winkelabstand benachbarter Magnetdrahtsensoren (25) ein ungeradzahliges Vielfaches des halben Winkelabstands der Permanentmagnete beträgt.

8. Winkelkodierer nach Anspruch 6 oder 7, dadurch gekennzeichnet, daß vier Magnetdrahtsensoren (25) und wenigstens fünf Paare von Permanentmagneten vorgesehen sind.

9. Winkelkodierer nach einem der Ansprüche 1 bis 8, dadurch gekennzeichnet, daß eine gerade Anzahl um gleiche Winkelabstände gegeneinander versetzter Magnetdrahtsensoren (25) in zwei Gruppen angeordnet sind, derart, daß die Magnetdrahtsensoren (25) der einen Gruppe jeweils zwischen Magnetdrahtsensoren (25) der anderen Gruppe gelegen sind, daß der Zählerschaltung (51) eine die Zählrichtung der Zählerschaltung (51) umschaltende Drehrichtungserkennungsschaltung (71) zugeordnet ist, die die Zählrichtung umkehrt, wenn zwei Impulse von Magnetdrahtsensoren (25) derselben Gruppe aufeinanderfolgen.

10. Winkelkodierer nach Anspruch 9, dadurch gekennzeichnet, daß die Drehrichtungserkennungsschaltung (71) auf Impulse von Magnetdrahtsensoren (25) beider Gruppen anspricht, die Zählerschaltung (51) jedoch ausschließlich Impulse von Magnetdrahtsensoren (25) einer einzigen der beiden Gruppen zählt.

# Fig.1

## Fig.2

## Fig.4

# Fig.3